# EUROPEAN PATENT APPLICATION

(11) **EP 4 738 428 A1**
(43) Date of publication of application: **06.05.2026**
(21) Application number: 24832002.0
(22) Date of filing: 26.06.2024
(51) Int. Cl.: H01L 21/304

(54) **SUBSTRATE PROCESSING METHOD**

(30) Priority: 29.06.2023 JP 2023106662
(71) Applicant: SCREEN Holdings Co., Ltd., Kyoto-shi, Kyoto 602-8585 (JP)
(72) Inventor: TAKEMATSU Yusuke, Kyoto-shi, Kyoto 602-8585 (JP); KATO Masahiko, Kyoto-shi, Kyoto 602-8585 (JP); ISHIZU Takaaki, Kyoto-shi, Kyoto 602-8585 (JP); NAKANO Akiyoshi, Kyoto-shi, Kyoto 602-8585 (JP); SHIRAO Takashi, Kyoto-shi, Kyoto 602-8585 (JP)
(74) Representative: Kilian Kilian & Partner mbB
(86) International application number: PCT/JP2024/023200
(87) International publication number: WO 2025/005143

(57) **Abstract**

Provided is a technique capable of effectively reducing a collapse rate of a pattern of a substrate. A substrate processing method includes a holding step, a liquid supply step, a drying liquid supply step, and a drying step. In the holding step, a substrate having a first main surface on which a pattern is formed and a second main surface on a side opposite to the first main surface is held. In the liquid supply step, a processing liquid is supplied to the first main surface of the substrate. In the drying liquid supply step, after the liquid supply step, a drying liquid is supplied to the first main surface of the substrate at a flow rate at which a temperature of the first main surface of the substrate is lower than a boiling point (bp) of the drying liquid while at least a portion of the second main surface of the substrate is heated to a temperature equal to or higher than the boiling point (bp) of the drying liquid. In the drying step, the substrate is dried after the drying liquid supply step.

## Description

### TECHNICAL FIELD

The present disclosure relates to a substrate processing method.

### BACKGROUND ART

Conventionally, a single wafer type substrate processing apparatus for processing a substrate has been disclosed (for example, Patent Document 1). In Patent Document 1, a substrate processing apparatus supplies a rinse liquid to a substrate, then supplies isopropyl alcohol having a surface tension lower than that of the rinse liquid to the substrate, and then dries the substrate. As a result, collapse of patterns of the substrate during drying is suppressed.

### PRIOR ART DOCUMENT

### PATENT DOCUMENT

Patent Document 1: Japanese Patent Application Laid-Open No. 2015-23182

### SUMMARY

### PROBLEM TO BE SOLVED BY THE INVENTION

However, Patent Document 1 does not consider a temperature of isopropyl alcohol. For this reason, a collapse rate of a pattern cannot be effectively reduced.

Therefore, an object of the present disclosure is to provide a technique capable of effectively reducing the collapse rate of the pattern of a substrate.

### MEANS TO SOLVE THE PROBLEM

A first aspect is a substrate processing method including: a holding step of holding a substrate having a first main surface on which a pattern is formed and a second main surface on a side opposite to the first main surface; a liquid supply step of supplying a processing liquid to the first main surface of the substrate; a drying liquid supply step of supplying a drying liquid to the first main surface of the substrate at a flow rate at which a temperature of the first main surface of the substrate is lower than a boiling point of the drying liquid while heating at least a portion of the second main surface of the substrate to a temperature equal to or higher than the boiling point of the drying liquid, after the liquid supply step; and a drying step of drying the substrate after the drying liquid supply step.

A second aspect is the substrate processing method according to the first aspect, in which in the drying liquid supply step, a heat medium having a temperature equal to or higher than the boiling point of the drying liquid is supplied to the second main surface of the substrate.

A third aspect is the substrate processing method according to the first or second aspect, in which in the drying liquid supply step, a peripheral edge portion of the second main surface of the substrate is heated to a temperature equal to or higher than the boiling point of the drying liquid.

A fourth aspect is the substrate processing method according to the third aspect, in which in the drying liquid supply step, a central portion of the second main surface of the substrate is heated to a temperature lower than the temperature of the peripheral edge portion of the second main surface.

A fifth aspect is the substrate processing method according to the fourth aspect, in which in the drying liquid supply step, a heat medium having a first medium temperature is supplied to the peripheral edge portion of the second main surface of the substrate, and a heat medium having a second medium temperature lower than the first medium temperature is supplied to the central portion of the second main surface of the substrate.

A sixth aspect is the substrate processing method according to any one of the first to fifth aspects, in which in the drying liquid supply step, the second main surface of the substrate is heated only during a latter time period of a drying liquid supply time during which the drying liquid is supplied.

A seventh aspect is the substrate processing method according to any one of the first to sixth aspects, in which in the drying liquid supply step, the temperature of the first main surface of the substrate is 60 degrees Celsius or higher and lower than the boiling point of the drying liquid.

### EFFECTS OF THE INVENTION

According to the first aspect, in the drying liquid supply step, while at least a portion of the second main surface of the substrate is heated to a temperature equal to or higher than the boiling point of the drying liquid, the drying liquid is supplied at a flow rate at which the temperature of the first main surface of the substrate is lower than the boiling point. For this reason, boiling of the drying liquid can be more reliably suppressed while the temperature of the first main surface of the substrate is brought closer to the boiling point of the drying liquid, and adhesion of particles can be suppressed. Then, since the temperature of the first main surface is close to the boiling point, the drying liquid can be evaporated in a shorter time in a state where the surface tension is lower in the subsequent drying step. Therefore, the collapse rate of the pattern can be effectively reduced.

According to the second aspect, the temperature of at least a portion of the second main surface of the substrate can be made equal to or higher than the boiling point of the drying liquid with a simple configuration.

According to the third aspect, the collapse rate of the pattern in the peripheral edge portion can be reduced. Since the collapse rate of the pattern in the peripheral edge portion tends to be higher than the collapse rate of the pattern in the central portion, the collapse rate of the pattern over the entire first main surface of the substrate can be reduced.

According to the fourth aspect, it is possible to further reduce an overall collapse rate of the pattern by reducing the collapse rate of the pattern at the central portion of the first main surface of the substrate while reducing power consumption.

According to the fifth aspect, it is possible to effectively reduce the collapse rate of the pattern over the entire first main surface of the substrate with a simple configuration.

According to the sixth aspect, power consumption can be reduced.

According to the seventh aspect, the collapse rate of the pattern can be effectively reduced.

### BRIEF DESCRIPTION OF DRAWINGS

[FIG. 1] is a plan view schematically illustrating an example of a configuration of a substrate processing apparatus.
[FIG. 2] is a block diagram schematically illustrating an example of an internal configuration of a control unit.
[FIG. 3] is a longitudinal sectional view schematically illustrating an example of the configuration of a processing unit according to a first embodiment.
[FIG. 4] is a flowchart illustrating an example of an operation of the processing unit.
[FIG. 5] is a diagram schematically illustrating an example of a state of the processing unit in a drying liquid supply step.
[FIG. 6] is a diagram schematically illustrating an example of a timing chart of the processing unit, a temporal change in a medium temperature of a heat medium, and a temporal change in a temperature of a first main surface of a substrate.
[FIG. 7] is a diagram schematically illustrating a first example of a substrate heating unit according to a second embodiment.
[FIG. 8] is a diagram schematically illustrating a first example of the configuration of a portion of a processing unit according to the second embodiment.
[FIG. 9] is a diagram schematically illustrating a second example of the substrate heating unit according to the second embodiment.
[FIG. 10] is a diagram schematically illustrating a second example of the configuration of a portion of the processing unit according to the second embodiment.
[FIG. 11] is a diagram schematically illustrating an example of a timing chart of a processing unit according to a third embodiment.
[FIG. 12] is a flowchart illustrating a first example of an operation of a processing unit according to a fourth embodiment.
[FIG. 13] is a flowchart illustrating a second example of the operation of the processing unit according to the fourth embodiment.
[FIG. 14] is a diagram schematically illustrating an example of the configuration of a processing unit according to a fifth embodiment.

### DESCRIPTION OF EMBODIMENTS

Hereinafter, embodiments will be described in detail with reference to the drawings. Note that, in the drawings, dimensions and the number of units are exaggerated or simplified as necessary for easy understanding. Further, portions having similar configurations and functions are denoted by the same reference numerals, and redundant description will be omitted in the following description.

Further, in the following description, similar components are illustrated with the same reference numerals, and names and functions thereof are also similar. Therefore, detailed description thereof may be omitted in order to avoid duplication.

Further, in the following description, even if ordinal numbers such as "first" or "second" are used, these terms are used for convenience to facilitate understanding of the contents of the embodiments, and are not limited to the order that can be implied by these ordinal numbers.

In a case where expressions indicating a relative or absolute positional relationship (e.g., "in one direction", "along one direction", "parallel", "orthogonal", "center", "concentric", "coaxial", etc.) are used, unless otherwise specified, the expressions shall not only strictly represent the positional relationship, but also represent a state where the position is relatively displaced relative to an angle or a distance within a range in which a tolerance or an equivalent function can be achieved. In a case where expressions indicating an equal state (for example, "same", "equal", "homogeneous", etc.) are used, unless otherwise specified, the expressions shall not only represent an equal state quantitatively and strictly, but also represent a state where a difference exists that allows for a tolerance or an equivalent function to be achieved. In a case where expressions indicating a shape (for example, "quadrangular" or "cylindrical") are used, unless otherwise specified, the expressions shall not only represent the shape geometrically and strictly, but also represent a shape having, for example, unevenness or chamfering within a range in which an equivalent effect can be achieved. In a case where expressions such as "comprise", "include", "be equipped with", "include" or "have" are used to describe one component, the expressions are not exclusive expressions that exclude the presence of other components. In a case where an expression "at least any one of A, B, and C" is used, the expression includes only A, only B, only C, any two of A, B and C, and all of A, B and C.

### <First Embodiment>

### <Overall Configuration of Substrate Processing Apparatus>

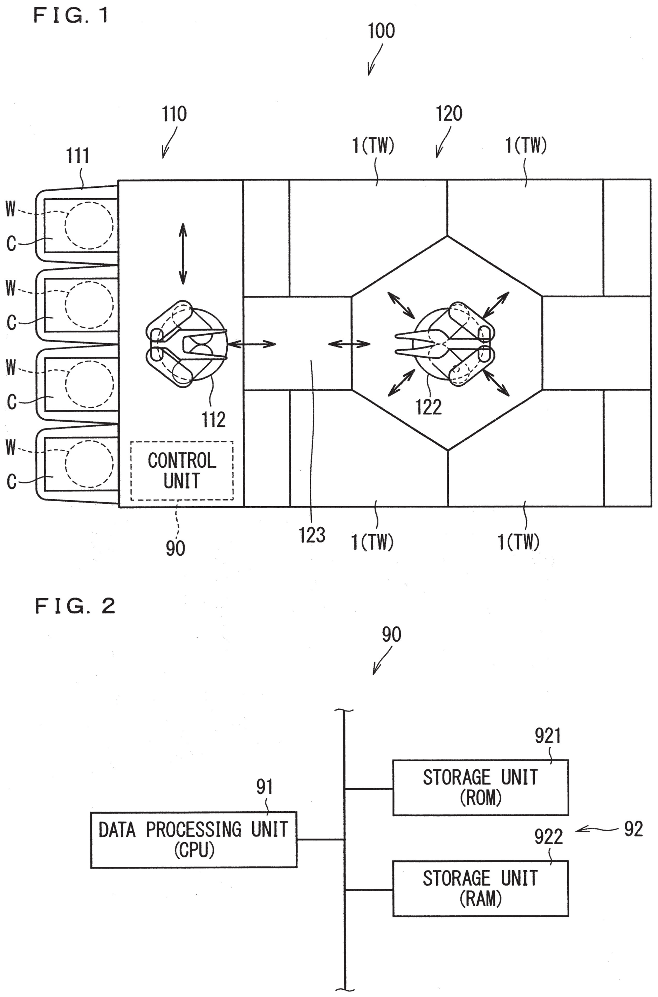

FIG. 1 is a plan view schematically illustrating an example of a configuration of a substrate processing apparatus 100. The substrate processing apparatus 100 is a single wafer type processing apparatus that processes a substrates W one by one.

The substrate W is, for example, a semiconductor wafer, a liquid crystal display substrate, an organic electroluminescence (EL) substrate, a flat panel display (FPD) substrate, an optical display substrate, a magnetic disk substrate, an optical disk substrate, a magneto-optical disk substrate, a photomask substrate, or a solar cell substrate. The substrate W has a thin flat plate shape having a first main surface Wa and a second main surface Wb. The second main surface Wb is a surface on a side opposite to the first main surface Wa. Hereinafter, it is assumed that the substrate W is a semiconductor wafer. The substrate W has, for example, a disk shape. A diameter of the substrate W is, for example, about 300 mm, and a thickness of the substrate W is, for example, about 0.5 mm or more and about 3 mm or less. A pattern is formed on the main surface of the substrate W. The pattern referred to here includes, for example, at least one of a wiring pattern, an electrode pattern, a semiconductor pattern, and an insulating pattern. An aspect ratio of the pattern is, for example, 5 or more and 500 or less. A pattern width is, for example, 3 nm or more and 50 nm or less. Such a high-aspect-ratio pattern is likely to collapse.

In the example of FIG. 1, the substrate processing apparatus 100 includes an indexer block 110, a processing block 120, and a control unit 90. The processing block 120 is a portion that mainly processes the substrate W, and the indexer block 110 is a portion that mainly transfers the substrate W between the outside of the substrate processing apparatus 100 and the processing block 120.

The indexer block 110 includes a load port 111 and a first transfer unit 112. A substrate container (hereinafter, referred to as a carrier) C carried in from the outside is placed on the load port 111. A plurality of substrates W are accommodated in the carrier C in a state of being arranged at intervals from each other in a vertical direction, for example. In the example of FIG. 1, a plurality of load ports 111 are arranged.

The first transfer unit 112 is a transfer robot, and can take out an unprocessed substrate W from the carrier C placed on each load port 111. The first transfer unit 112 may also be referred to as an indexer robot. The first transfer unit 112 transfers the unprocessed substrate W taken out from the carrier C to the processing block 120. The processing block 120 can perform processing on the unprocessed substrate W. Further, the first transfer unit 112 can receive a processed substrate W from the processing block 120 and transfer the processed substrate W to the carrier C of the load port 111.

In the example of FIG. 1, the processing block 120 includes a plurality of processing units 1 and a second transfer unit 122. The second transfer unit 122 is a transfer robot, and can transfer the substrate W between the first transfer unit 112 and the plurality of processing units 1. In the example of FIG. 1, the processing block 120 also includes a placement unit 123. The placement unit 123 is, for example, a shelf on which a plurality of substrates W can be placed in a state of being arranged in the vertical direction. The first transfer unit 112 places an unprocessed substrate W on the placement unit 123. The second transfer unit 122 takes out the unprocessed substrate W from the placement unit 123 and transfers the substrate W to the processing unit 1. The processing unit 1 processes the substrate W. The configuration of the processing unit 1 will be described later. The second transfer unit 122 takes out a processed substrate W from the processing unit 1 and transfers the substrate W to the placement unit 123. The first transfer unit 112 takes out the substrate W from the placement unit 123 and transfers the substrate W to the carrier C of the load port 111.

In the example of FIG. 1, a plurality of (for example, four) processing units 1 are provided so as to surround the second transfer unit 122 in plan view. The second transfer unit 122 may also be referred to as a center robot. The plurality of processing units 1 may be stacked in the vertical direction at each position in plan view. In other words, a plurality of (four in the drawing) towers TW composed of the plurality of processing units 1 stacked in the vertical direction may be provided so as to surround the second transfer unit 122.

The control unit 90 integrally controls the substrate processing apparatus 100. Specifically, the control unit 90 controls the first transfer unit 112, the second transfer unit 122, and the processing unit 1. FIG. 2 is a block diagram schematically illustrating an example of an internal configuration of the control unit 90. The control unit 90 is an electronic circuit, and includes, for example, a data processing unit 91 and a storage unit 92. In the specific example of FIG. 2, the data processing unit 91 and the storage unit 92 are connected to each other via a bus 93. The data processing unit 91 may be, for example, an arithmetic processing unit such as a Central Processor Unit (CPU). The storage unit 92 may include a non-transitory storage unit (for example, a read only memory (ROM)) 921 and a temporary storage unit (for example, a random access memory (RAM)) 922. The non-transitory storage unit 921 may store, for example, a program that defines processing to be executed by the control unit 90. When the data processing unit 91 executes this program, the control unit 90 can execute the processing defined in the program. Of course, a part or all of the processing to be executed by the control unit 90 may be executed by hardware such as a dedicated logic circuit.

### <Outline of Processing Unit>

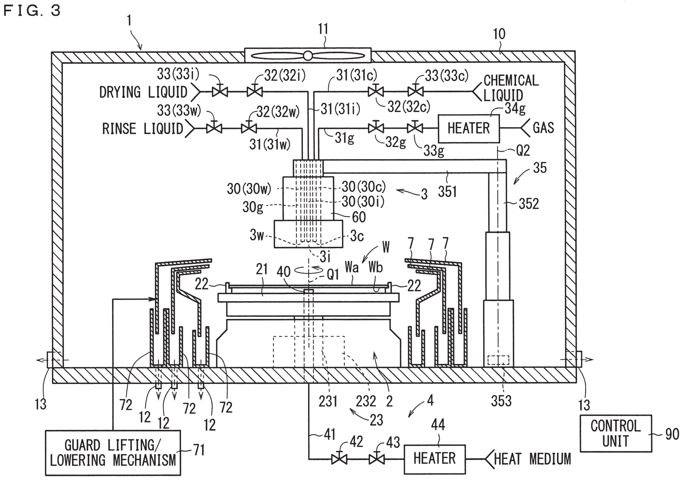

FIG. 3 is a longitudinal sectional view schematically illustrating an example of the configuration of the processing unit 1 according to the first embodiment. Note that not all the processing units 1 belonging to the substrate processing apparatus 100 need to have the configuration illustrated in FIG. 3. It is sufficient that at least one processing unit 1 of the substrate processing apparatus 100 has the configuration illustrated in FIG. 3.

The processing unit 1 includes a substrate holding unit 2, a dispenser 3, and a substrate heating unit 4.

In the example of FIG. 3, the processing unit 1 is also provided with a chamber 10. The chamber 10 has a box-like shape, and an internal space thereof corresponds to a processing space where the substrate W is processed. The chamber 10 is provided with an openable/closable transfer port (not illustrated). The second transfer unit 122 transfers an unprocessed substrate W into the chamber 10 through the transfer port, and transfers a processed substrate W out of the chamber 10 through the transfer port.

In the example of FIG. 3, a fan filter unit 11 is provided on a ceiling portion of the chamber 10. The fan filter unit 11 takes in air from outside the chamber 10, purifies it, and then blows the purified air into the chamber 10. Activation of the fan filter unit 11 creates a downflow of clean air in the chamber 10. In the example of FIG. 3, an upstream end of an exhaust pipe 13 is connected to a lower portion of a side wall of the chamber 10. A gas in the chamber 10 is discharged to the outside through the exhaust pipe 13.

The substrate holding unit 2 is provided in the chamber 10, and rotates the substrate W around a rotation axis Q1 while holding the substrate W in a horizontal orientation. The horizontal orientation referred to here is an orientation in which a thickness direction of the substrate W is along the vertical direction. The rotation axis Q1 is an axis passing through the center of the substrate W and extending along the vertical direction. Such a substrate holding unit 2 may also be referred to as a spin chuck.

Here, the first main surface Wa of the substrate W on which a pattern is formed faces vertically upward. In other words, in the example of FIG. 3, the first main surface Wa of the substrate W held by the substrate holding unit 2 corresponds to an upper surface. The pattern includes, for example, at least one of a wiring pattern, an insulating pattern, and a semiconductor pattern.

In the example of FIG. 3, the substrate holding unit 2 includes a spin base 21, a chuck pin 22, and a rotation drive unit 23. The spin base 21 has a plate-like shape (for example, a disk shape), and is provided in an orientation in which the thickness direction thereof is along the vertical direction. A plurality of chuck pins 22 are provided on the upper surface of the spin base 21. The plurality of chuck pins 22 are provided at equal intervals along a circumferential direction around the rotation axis Q1. The plurality of chuck pins 22 are provided so as to be displaceable between a holding position and a release position to be described below. The holding position is a position where the chuck pin 22 abuts on a peripheral edge of the substrate W. When the plurality of chuck pins 22 stop at the respective holding positions, the plurality of chuck pins 22 hold the substrate W. FIG. 3 illustrates the chuck pin 22 stopped at the holding position. The release position is a position where each chuck pin 22 is separated from the substrate W. When the plurality of chuck pins 22 stop at the respective release positions, holding of the substrate W by the plurality of chuck pins 22 is released. The substrate holding unit 2 also includes a pin drive unit (not illustrated) that displaces the chuck pins 22. The pin drive unit includes, for example, a drive source such as a motor and an air cylinder, and is controlled by the control unit 90.

The rotation drive unit 23 includes a shaft 231 and a motor 232. An upper end of the shaft 231 is connected to a lower surface of the spin base 21, and the shaft 231 extends from the lower surface of the spin base 21 along the rotation axis Q1. The motor 232 is controlled by the control unit 90 to rotate the shaft 231 around the rotation axis Q1. As a result, the spin base 21, the chuck pin 22, and the substrate W rotate integrally around the rotation axis Q1.

Note that the substrate holding unit 2 does not necessarily need to have the chuck pins 22. For example, the substrate holding unit 2 may hold the substrate W by a chuck method such as a vacuum chuck, an electrostatic chuck, or a Bernoulli chuck.

The dispenser 3 dispenses a processing liquid toward the first main surface Wa of the substrate W held by the substrate holding unit 2. As illustrated in FIG. 3, the dispenser 3 includes at least one nozzle 30. The nozzle 30 dispenses the processing liquid toward the first main surface Wa of the substrate W held by the substrate holding unit 2. Here, since the first main surface Wa corresponds to the upper surface of the substrate W, the nozzle 30 is provided vertically above the substrate W held by the substrate holding unit 2. The nozzle 30 is, for example, a straight nozzle that dispenses the processing liquid in a continuous flow state.

In the example of FIG. 3, a nozzle 30c, a nozzle 30w, and a nozzle 30i are illustrated as the nozzle 30. In the example of FIG. 3, the nozzle 30c, the nozzle 30w, and the nozzle 30i extend along the vertical direction. In the example of FIG. 3, a dispense port 3c is formed on the lower surface of the nozzle 30c, a dispense port 3w is formed on the lower surface of the nozzle 30w, and a dispense port 3i is formed on the lower surface of the nozzle 30i. The nozzle 30c dispenses a chemical liquid from the dispense port 3c, the nozzle 30w dispenses a rinse liquid from the dispense port 3w, and the nozzle 30i dispenses a drying liquid from the dispense port 3i. The chemical liquid, the rinse liquid, and the drying liquid are all examples of the processing liquid, and specific examples thereof will be described later.

The nozzle 30c, the nozzle 30w, and the nozzle 30i dispense the processing liquid toward a central portion of the first main surface Wa of the substrate W held by the substrate holding unit 2. In the example of FIG. 3, the nozzle 30c, the nozzle 30w, and the nozzle 30i are adjacent to each other in a horizontal direction and are fixed to each other. In the example of FIG. 3, the nozzle 30c, the nozzle 30w, and the nozzle 30i are provided inside an opposing member 60. The opposing member 60 has, for example, a cylindrical shape. The opposing member 60 has a hollow shape, and a lower end port of the hollow portion is opened on the lower surface of the opposing member 60. The nozzle 30c, the nozzle 30w, and the nozzle 30i are provided in the hollow portion of the opposing member 60, and the processing liquid dispensed from each nozzle 30 flows out from the lower end port of the opposing member 60. In the example of FIG. 3, the opposing member 60 is provided at a position facing the central portion of the substrate W held by the substrate holding unit 2 in the vertical direction.

The nozzle 30 is connected to a downstream end of a supply pipe 31, and the upstream end of the supply pipe 31 is connected to a processing liquid supply source. In the example of FIG. 3, a supply pipe 31c, a supply pipe 31w, and a supply pipe 31i are illustrated as the supply pipe 31.

The downstream end of the supply pipe 31c is connected to the nozzle 30c, and the upstream end of the supply pipe 31c is connected to a chemical liquid supply source. The chemical liquid supply source includes a tank (not illustrated) that stores a chemical liquid, and supplies the chemical liquid to the upstream end of the supply pipe 31c. As the chemical liquid, for example, liquids such as fluoronitric acid obtained by mixing hydrofluoric acid, nitric acid, and water, hydrofluoric acid hydrogen peroxide aqueous solution (FPM) obtained by mixing hydrofluoric acid, hydrogen peroxide, and water, tetramethylammonium hydroxide (TMAH), a mixture (SPM) of sulfuric acid and hydrogen peroxide water, ammonia water, a mixture (SC-1) of ammonia, hydrogen peroxide, and water, and a mixture (SC-2) of hydrogen chloride, hydrogen peroxide, and water can be applied. Note that the chemical liquid may be a single liquid instead of a mixture. For example, a single liquid such as hydrofluoric acid (HF), hydrogen peroxide water, and sulfuric acid can be applied as the chemical liquid.

The downstream end of the supply pipe 31w is connected to the nozzle 30w, and the upstream end of the supply pipe 31w is connected to a rinse liquid supply source. The rinse liquid supply source includes a tank (not illustrated) that stores a rinse liquid, and supplies the rinse liquid to the upstream end of the supply pipe 31w. As the rinse liquid, for example, pure water, carbon dioxide water, or ozone water can be applied.

The downstream end of the supply pipe 31i is connected to the nozzle 30i, and the upstream end of the supply pipe 31i is connected to a drying liquid supply source. The drying liquid supply source has a tank (not illustrated) that stores a drying liquid, and supplies the drying liquid to the upstream end of the supply pipe 31i. As the drying liquid, for example, an organic solvent such as isopropyl alcohol can be applied. The surface tension of the drying liquid is lower than the surface tension of other processing liquids (for example, both the surface tension of the chemical liquid and the surface tension of the rinse liquid). Further, volatility of the drying liquid is higher than the volatility of other processing liquids (for example, both the volatility of the chemical liquid and the volatility of the rinse liquid).

A supply valve 32 and a flow rate control valve 33 are interposed in the supply pipe 31. In the example of FIG. 3, a supply valve 32c and a flow rate control valve 33c are interposed in the supply pipe 31c, a supply valve 32w and a flow rate control valve 33w are interposed in the supply pipe 31w, and a supply valve 32i and a flow rate control valve 33i are interposed in the supply pipe 31i. The supply valve 32 switches opening and closing of the supply pipe 31. The flow rate control valve 33 adjusts the flow rate of the processing liquid flowing through the supply pipe 31. The flow rate control valve 33 may be a mass flow controller. The supply valve 32 and the flow rate control valve 33 are controlled by the control unit 90.

The dispenser 3 dispenses various processing liquids toward the first main surface Wa of the substrate W in the order to be described later. As a result, the processing unit 1 can sequentially perform various processing on the first main surface Wa of the substrate W according to the type of processing liquid. Specific processing will be described later.

In the example of FIG. 3, the opposing member 60 is configured to be capable of dispensing a gas toward the first main surface Wa of the substrate W held by the substrate holding unit 2. In the example of FIG. 3, a space other than the nozzle 30 in the hollow portion of the opposing member 60 functions as a gas flow path 30g. The lower end port of the lower surface of the opposing member 60 corresponds to a dispense port of the gas flow path 30g.

In the example of FIG. 3, an upper portion of the opposing member 60 is connected to the downstream end of a supply pipe 31g. In other words, the downstream end of the supply pipe 31g is connected to the gas flow path 30g. The upstream end of the supply pipe 31g is connected to a gas supply source. The gas supply source includes a storage unit (not illustrated) that stores an inert gas, and supplies the inert gas to the upstream end of the supply pipe 31g. The inert gas includes, for example, at least one of nitrogen gas and a rare gas. The rare gas includes, for example, argon gas.

The supply pipe 31g is provided with a supply valve 32g, a flow rate control valve 33g, and a heater 34g. The supply valve 32g switches opening and closing of the supply pipe 31g. The flow rate control valve 33g adjusts the flow rate of the inert gas flowing through the supply pipe 31g. The heater 34g heats the inert gas flowing through the supply pipe 31g. The heater 34g may be, for example, an electric resistance type heater having an electric heating wire. The supply valve 32g, the flow rate control valve 33g, and the heater 34g are controlled by the control unit 90.

When the supply valve 32g is opened and the heater 34g is activated, a high-temperature inert gas is dispensed from the central portion of the lower surface of the opposing member 60 (that is, the lower end port of the gas flow path 30g) toward the central portion of the first main surface Wa of the substrate W. As a result, drying of the substrate W can be promoted.

In the example of FIG. 3, the processing unit 1 is provided with a movement drive unit 35. The movement drive unit 35 integrally moves a dispense head including the nozzle 30c, the nozzle 30w, the nozzle 30i, and the opposing member 60. Specifically, the movement drive unit 35 moves the dispense head between a processing position and a standby position to be described below. The processing position is a position where the nozzle 30c, the nozzle 30w, and the nozzle 30i dispense the processing liquid toward the first main surface Wa of the substrate W, and is, for example, a position facing the central portion of the first main surface Wa of the substrate W in the vertical direction. The processing position is also a position where the opposing member 60 dispenses the inert gas toward the first main surface Wa of the substrate W. In the example of FIG. 3, the dispense head stopped at the processing position is illustrated. The standby position is a position where the nozzle 30c, the nozzle 30w, and the nozzle 30i do not dispense the processing liquid toward the first main surface Wa of the substrate W, and is, for example, a position radially outward from the substrate holding unit 2. The standby position is also a position where the opposing member 60 does not dispense the inert gas toward the first main surface Wa of the substrate W.

FIG. 3 illustrates an example of a specific configuration of the movement drive unit 35. In the example of FIG. 3, the movement drive unit 35 includes an arm 351, a support column 352, and a drive source 353. The support column 352 is provided radially outward from a guard 7 to be described later, and extends along the vertical direction. The arm 351 extends along the horizontal direction, and has a distal end connected to the dispense head and a proximal end connected to the support column 352. The drive source 353 is controlled by the control unit 90, and rotates the support column 352 in forward and reverse directions within a predetermined angular range around the central axis Q2 thereof. The drive source 353 includes, for example, a motor. When the support column 352 rotates in forward and reverse directions within a predetermined angular range around the central axis Q2, the dispense head reciprocates along the circumferential direction around the central axis Q2. The support column 352 is installed such that the processing position and the standby position are located on a movement trajectory of the dispense head. Note that the movement drive unit 35 is not necessarily limited to the configuration shown in FIG. 3, and may include a linear motion mechanism such as a linear motor, for example.

The substrate heating unit 4 heats the second main surface Wb of the substrate W held by the substrate holding unit 2. In the example of FIG. 3, the substrate heating unit 4 is provided at a position facing the second main surface Wb of the substrate W in the vertical direction. In the example of FIG. 3, since the second main surface Wb of the substrate W corresponds to the lower surface, the substrate heating unit 4 is provided directly below the substrate W. The substrate heating unit 4 heats at least a portion of the second main surface Wb of the substrate W to a temperature equal to or higher than the boiling point of the drying liquid. A technical significance of this will be described later.

In the example of FIG. 3, the substrate heating unit 4 includes a nozzle 40. The nozzle 40 dispenses a heat medium toward the second main surface Wb of the substrate W. In the example of FIG. 3, since the second main surface Wb of the substrate W corresponds to the lower surface, the nozzle 40 may also be referred to as a lower surface nozzle. In the example of FIG. 3, a through hole is formed in the central portion of the spin base 21 of the substrate holding unit 2, and the shaft 231 is a hollow shaft. The through hole of the spin base 21 and the hollow portion of the shaft 231 are connected in the vertical direction. A part of the nozzle 40 is disposed in the through hole. A dispense port is formed on the upper surface of the nozzle 40, and the dispense port of the nozzle 40 faces the central portion of the second main surface Wb of the substrate W in the vertical direction. The nozzle 40 dispenses the heat medium toward the central portion of the second main surface Wb of the substrate W.

The downstream end of a supply pipe 41 is connected to the nozzle 40. The supply pipe 41 extends inside the shaft 231 and passes through the shaft 231. The upstream end of the supply pipe 41 is connected to a heat medium supply source. The heat medium is a fluid (gas or liquid), and is a liquid such as water as a more specific example. The heat medium supply source includes, for example, a tank (not illustrated) that stores a heat medium, and supplies the heat medium to the upstream end of the supply pipe 41.

In the example of FIG. 3, the supply pipe 41 is provided with a supply valve 42, a flow rate control valve 43, and a heater 44. The supply valve 42 switches opening and closing of the supply pipe 41. The flow rate control valve 43 adjusts the flow rate of the heat medium flowing through the supply pipe 41. The flow rate control valve 43 may be a mass flow controller. The heater 44 heats the heat medium flowing through the supply pipe 41. The heater 44 may be, for example, an electric resistance type heater having an electric heating wire. The supply valve 42, the flow rate control valve 43, and the heater 44 are controlled by the control unit 90.

When the supply valve 42 is opened and the heater 44 is activated, a high-temperature heat medium is dispensed from the nozzle 40 to the central portion of the second main surface Wb of the substrate W. The heat medium that has landed at the central portion of the second main surface Wb of the substrate W receives a centrifugal force accompanying the rotation of the substrate W, flows radially outward along the second main surface Wb, and scatters outward from the peripheral edge of the substrate W. When the high-temperature heat medium flows along the second main surface Wb of the substrate W, heat is transferred from the heat medium to the substrate W, thereby heating the substrate W.

In the example of FIG. 3, the processing unit 1 is provided with a guard 7 and a guard lifting/lowering drive unit 71. The guard 7 has a tubular shape with the rotation axis Q1 as a central axis, and surrounds the substrate holding unit 2. The guard 7 can catch the processing liquid and the heat medium scattered from the peripheral edge of the substrate W. The guard 7 is lifted and lowered by the guard lifting/lowering drive unit 71 between an upper position and a lower position to be described below. The upper position is a position where the upper end of the guard 7 is vertically above the substrate W held by the substrate holding unit 2. The guard 7 can catch the processing liquid and the heat medium scattered from the peripheral edge of the substrate W in a state of being located at the upper position. The lower position is a position lower than the upper position, and is, for example, a position where the upper end of the guard 7 is vertically below the upper surface of the spin base 21.

In the example of FIG. 3, a plurality of guards 7 are provided. The plurality of guards 7 are arranged concentrically. The plurality of guards 7 may be selectively used according to the type of processing liquid. In the example of FIG. 3, a cup 72 corresponding to each guard 7 is provided. The cup 72 has an annular (for example, circular) recess (groove) surrounding the rotation axis Q1. Each cup 72 catches the processing liquid flowing down on an inner peripheral surface of the corresponding guard 7. The upstream end of a discharge pipe 12 is connected to, for example, a bottom of each cup 72. The processing liquid caught by each cup 72 is discharged to the outside of the processing unit 1 through the discharge pipe 12.

### <Example of Operation of Substrate Processing Apparatus>

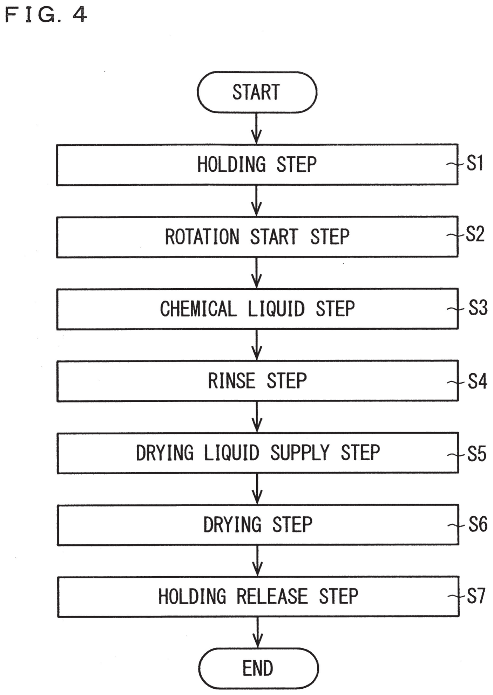

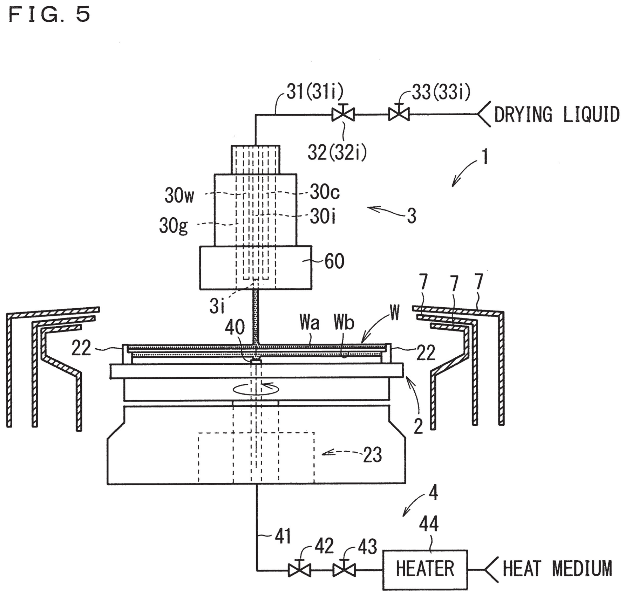

Next, an example of the operation of the processing unit 1 will be described. FIG. 4 is a flowchart illustrating an example of the operation of the processing unit 1. The control unit 90 causes the processing unit 1 to execute the processing of steps S1 to S7 in accordance with a preset processing procedure (recipe). FIG. 5 is a diagram schematically illustrating an example of a state of the processing unit 1 in a drying liquid supply step to be described later.

First, the second transfer unit 122 transfers the substrate W to the processing unit 1. Then, the substrate holding unit 2 holds the substrate W received from the second transfer unit 122 (step S1: holding step). As a specific example, the substrate holding unit 2 displaces the plurality of chuck pins 22 from the respective release positions to the holding positions. As a result, the plurality of chuck pins 22 hold the substrate W. The substrate holding unit 2 continues to hold the substrate W until the processing on the substrate W is completed.

Next, the substrate holding unit 2 starts rotation of the substrate W (step S2: rotation start step). The substrate holding unit 2 may continue rotating the substrate W until the processing of the substrate W is completed.

Next, the processing unit 1 supplies a chemical liquid to the first main surface Wa of the substrate W (step S3: chemical liquid step). First, the movement drive unit 35 moves the dispense head to the processing position. Further, the guard lifting/lowering drive unit 71 lifts the guard 7 for the chemical liquid to the upper position. Then, the control unit 90 opens the supply valve 32c. In other words, the control unit 90 switches the supply valve 32c from a closed state to an open state. As a result, the chemical liquid is dispensed from the nozzle 30c toward the first main surface Wa of the rotating substrate W. The chemical liquid that has landed on the first main surface Wa of the substrate W flows radially outward by receiving a centrifugal force accompanying the rotation of the substrate W and scatters from the peripheral edge of the substrate W. At this time, the chemical liquid acts on the first main surface Wa of the substrate W, so that the chemical liquid processing corresponding to the type of chemical liquid is performed on the first main surface Wa of the substrate W. For example, the processing unit 1 performs a cleaning processing of cleaning and removing impurities on the first main surface Wa of the substrate W or an etching processing of etching a predetermined film of the first main surface Wa of the substrate W. The chemical liquid scattered from the peripheral edge of the substrate W is caught by the guard 7 and discharged to the outside of the chamber 10 through the discharge pipe 12.

When the processing on the substrate W is sufficiently performed, the control unit 90 closes the supply valve 32c. As a specific example, the control unit 90 measures an elapsed time from the start of dispense of the chemical liquid, and determines whether or not the elapsed time is equal to or longer than a predetermined chemical liquid time. The chemical liquid time is set in advance to a time period during which the chemical liquid processing is sufficiently performed. The elapsed time is measured by, for example, a timer circuit (not illustrated) belonging to the control unit 90. The control unit 90 switches the supply valve 32c from the open state to the closed state when the elapsed time is equal to or longer than the chemical liquid time.

Next, the processing unit 1 supplies a rinse liquid to the first main surface Wa of the substrate W (step S4: rinse step). In a case where the guard 7 for the rinse liquid is different from the guard 7 for the chemical liquid, the guard lifting/lowering drive unit 71 appropriately lifts and lowers the guard 7 to position the guard 7 for the rinse liquid at the upper position. Then, the control unit 90 opens the supply valve 32w. In other words, the control unit 90 switches the supply valve 32w from the closed state to the open state. As a result, the rinse liquid is dispensed from the nozzle 30w toward the first main surface Wa of the rotating substrate W. The rinse liquid that has landed on the first main surface Wa of the substrate W flows radially outward by receiving a centrifugal force accompanying the rotation of the substrate W and scatters from the peripheral edge of the substrate W. At this time, the rinse liquid pushes the chemical liquid on the first main surface Wa of the substrate W radially outward. As a result, the processing liquid on the first main surface Wa of the substrate W is replaced from the chemical liquid to the rinse liquid. The processing liquid scattered from the peripheral edge of the substrate W is caught by the guard 7 and discharged to the outside of the chamber 10 through the discharge pipe 12.

When replacement from the chemical liquid to the rinse liquid is sufficiently performed, the control unit 90 closes the supply valve 32w. As a specific example, the control unit 90 measures an elapsed time from the start of dispense of the rinse liquid, and switches the supply valve 32w from the open state to the closed state when the elapsed time becomes equal to or longer than a predetermined rinse time. The rinse time is set in advance to a time period during which the replacement from the chemical liquid to the rinse liquid is sufficiently performed.

Next, the processing unit 1 supplies a drying liquid to the first main surface Wa of the substrate W (step S5: drying liquid supply step). In a case where the guard 7 for the drying liquid is different from the guard 7 for the rinse liquid, the guard lifting/lowering drive unit 71 appropriately lifts and lowers the guard 7 to lift the guard 7 for the drying liquid to the upper position. Then, the control unit 90 opens the supply valve 32i. In other words, the control unit 90 switches the supply valve 32i from the closed state to the open state.

When the supply valve 32i is opened, as illustrated in FIG. 5, the drying liquid is dispensed from the dispense port 3i of the nozzle 30i toward the first main surface Wa of the rotating substrate W. The temperature of the drying liquid may be, for example, normal temperature (for example, about 25 degrees Celsius). The temperature of the drying liquid referred to here is, for example, the temperature of the drying liquid at the dispense port 3i. Further, the normal temperature referred to here includes, for example, the temperature of the drying liquid when a heater for heating the drying liquid is not provided upstream of the dispense port 3i or when the heater is not operating. In other words, the normal temperature includes the temperature of the drying liquid that is not heated.

The drying liquid from the nozzle 30i lands at the central portion of the first main surface Wa of the substrate W. The drying liquid that has landed on the first main surface Wa flows radially outward by receiving a centrifugal force accompanying the rotation of the substrate W and scatters from the peripheral edge of the substrate W. At this time, the drying liquid pushes the rinse liquid on the first main surface Wa of the substrate W, so that the processing liquid on the first main surface Wa of the substrate W is replaced from the rinse liquid to the drying liquid. The processing liquid scattered from the peripheral edge of the substrate W is caught by the guard 7 and discharged to the outside of the chamber 10 through the discharge pipe 12.

Here, a rotation speed of the substrate W in the drying liquid supply step may be set to, for example, 150 rpm or more and 600 rpm or less, or may be set to 200 rpm or more and 400 rpm or less. As a more specific example, the rotation speed may be set to 300 rpm.

Further, the processing unit 1 heats the second main surface Wb of the substrate W when the drying liquid is supplied. In other words, the substrate heating unit 4 heats the second main surface Wb of the substrate W. As a more specific example, the control unit 90 opens the supply valve 42 and activates the heater 44. According to this, as illustrated in FIG. 5, a high-temperature heat medium (for example, hot water) is dispensed from the nozzle 40 toward the central portion of the second main surface Wb of the rotating substrate W. The heat medium that has landed at the central portion of the second main surface Wb of the substrate W flows radially outward by receiving a centrifugal force accompanying the rotation of the substrate W and scatters from the peripheral edge of the substrate W. When the high-temperature heat medium flows along the second main surface Wb of the substrate W, heat is transferred from the heat medium to the substrate W, thereby heating the substrate W. The heat of the substrate W is transferred to the drying liquid on the first main surface Wa. For this reason, the drying liquid on the first main surface Wa of the substrate W is also heated and the temperature rises.

The substrate heating unit 4 heats the second main surface Wb of the substrate W so that the temperature of at least a portion (here, the central portion) of the second main surface Wb of the substrate W becomes equal to or higher than the boiling point of the drying liquid. For example, the heater 44 heats the heat medium so that the temperature of the heat medium (hereinafter, also referred to as a medium temperature) becomes equal to or higher than the boiling point of the drying liquid. The medium temperature of the heat medium referred to here is, for example, the temperature of the heat medium at the dispense port of the nozzle 40. In a case where the drying liquid is isopropyl alcohol, the boiling point is 82.4 degrees Celsius, and the medium temperature of the heat medium is set to, for example, about 85 degrees Celsius. However, the medium temperature of the heat medium can be set to be lower than the boiling point of the heat medium. For example, in a case where the heat medium is water, the temperature may be set to below 90 degrees Celsius that is 10 degrees lower than the boiling point (100 degrees Celsius). According to this, it is possible to comply with SEMI standards.

The flow rate control valve 43 may adjust the flow rate of the heat medium to, for example, a value greater than the flow rate of the drying liquid. More specifically, the flow rate control valve 43 may adjust the flow rate of the heat medium to 1000 mL/min or more, or 1500 mL/min or more.

The nozzle 30i dispenses a drying liquid having a temperature lower than that of the heat medium. For this reason, a drying liquid with a low temperature is continuously supplied to the first main surface Wa of the substrate W. Therefore, the drying liquid with a low temperature can cool the first main surface Wa of the substrate W. A cooling capacity of the drying liquid increases as the flow rate of the drying liquid increases. Therefore, the flow rate control valve 33i adjusts the flow rate of the drying liquid to a value at which the temperature of the first main surface Wa of the substrate W is lower than the boiling point. For example, the flow rate of the drying liquid can be set in advance to about 100 mL/min or more, more specifically 250 mL/min or more.

As described above, in the drying liquid supply step, the processing unit 1 supplies the drying liquid to the first main surface Wa of the substrate W at a flow rate at which the temperature of the first main surface Wa of the substrate W becomes lower than the boiling point of the drying liquid while heating at least a portion of the second main surface Wb of the substrate W to a temperature equal to or higher than the boiling point of the drying liquid.

When the replacement from the rinse liquid to the drying liquid is sufficiently performed, the processing unit 1 dries the substrate W (step S6: drying step). Specifically, the processing unit 1 measures an elapsed time from the start of dispense of the drying liquid, and determines whether or not the elapsed time is equal to or longer than a predetermined drying liquid supply time. The drying liquid supply time is set in advance to a time period during which the replacement from the rinse liquid to the drying liquid is sufficiently performed. The drying liquid supply time is set to, for example, about several tens of seconds or more, and can be set to about 40 seconds as a specific example. Then, when the elapsed time is equal to or longer than the drying liquid supply time, the processing unit 1 dries the substrate W. Specifically, the control unit 90 closes the supply valve 32i. Further, the substrate heating unit 4 stops heating the second main surface Wb of the substrate W.

Furthermore, the control unit 90 causes the substrate holding unit 2 to increase the rotation speed of the substrate W. For example, the substrate holding unit 2 may rotate the substrate W at a rotation speed of, for example, 800 rpm or more and 2500 rpm or less, or may rotate the substrate W at a rotation speed of 800 rpm or more and 1500 rpm or less. Further, the substrate holding unit 2 may gradually (for example, stepwise) increase the rotation speed of the substrate W.

The processing unit 1 may supply an inert gas toward the central portion of the first main surface Wa of the substrate W. Specifically, the control unit 90 may open the supply valve 32g and activate the heater 34g. As a result, a high-temperature inert gas is dispensed from a gas dispense port at the central portion of the lower surface of the opposing member 60 (that is, the lower end port of the gas flow path 30g) toward the central portion of the first main surface Wa of the substrate W. The inert gas hitting the central portion of the first main surface Wa of the substrate W flows radially outward along the first main surface Wa. The heater 34g may heat the inert gas to, for example, 60 degrees Celsius or higher, 70 degrees Celsius or higher, or 80 degrees Celsius or higher. The temperature of the inert gas may be, for example, the temperature of the inert gas at the gas dispense port of the gas flow path 30g. The flow rate control valve 33g may adjust the flow rate of the inert gas to, for example, 10 L (liter)/min or more and 300 L/min or less.

When the drying liquid is sufficiently evaporated, the processing unit 1 stops the rotation of the substrate W while stopping the dispense of the inert gas. As a specific example, the control unit 90 measures an elapsed time from the stop of the dispense of the drying liquid, and determines whether or not the measured time is equal to or longer than a predetermined drying time. The drying time is set in advance to a time period during which the substrate W is sufficiently dried. When the elapsed time is equal to or longer than the drying time, the control unit 90 switches the supply valve 32g from the open state to the closed state, and causes the substrate holding unit 2 to stop the rotation of the substrate W. Further, the movement drive unit 35 moves the dispense head to the standby position, and the guard lifting/lowering drive unit 71 lowers the guard 7 to the lower position.

Next, the substrate holding unit 2 releases the holding on the substrate W (step S7: holding release step). Then, the second transfer unit 122 takes out the processed substrate W from the processing unit 1.

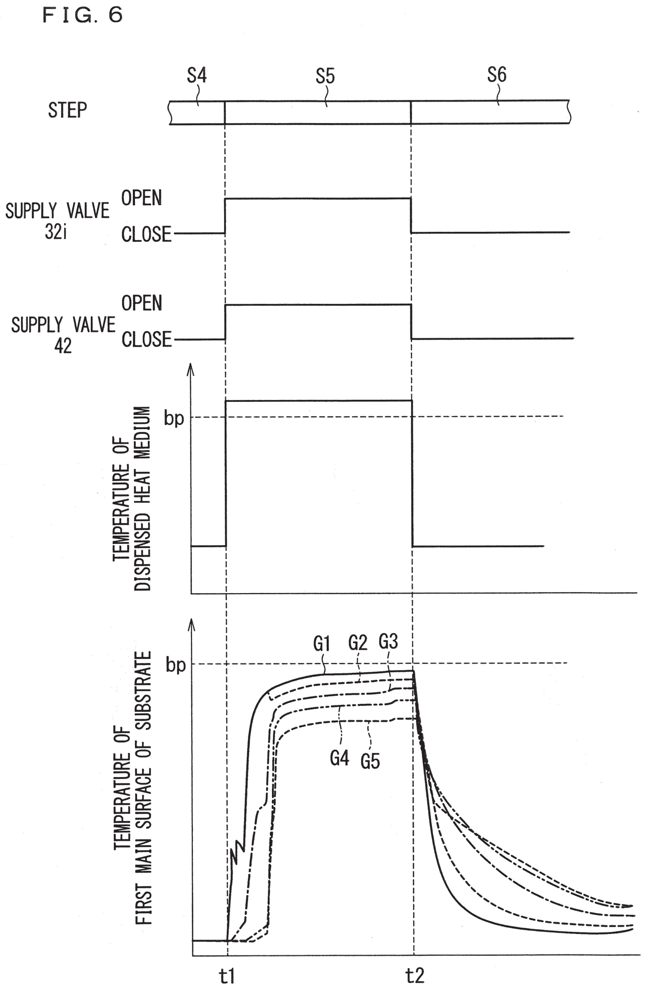

As described above, the processing unit 1 can perform processing on the substrate W. Moreover, in the present embodiment, the substrate heating unit 4 heats the substrate W in the drying liquid supply step after a liquid supply step including the chemical liquid step and the rinse step. FIG. 6 is a diagram schematically illustrating an example of a timing chart of the processing unit 1, a temporal change in the medium temperature of the heat medium, and a temporal change in the temperature of the first main surface Wa of the substrate W. Hereinafter, the temperature of the first main surface Wa of the substrate W is also referred to as a substrate temperature. In the example of FIG. 6, the substrate temperatures at different positions in a radial direction on the first main surface Wa of the substrate W are illustrated as graphs G1 to G5. The graphs G1 to G5 are closer to the rotation axis Q1 as the number of the sign thereof decreases. In other words, the graph G1 indicates the substrate temperature on a most center side of the first main surface Wa of the substrate W, and the graph G5 indicates the substrate temperature on a most peripheral edge portion side of the first main surface Wa of the substrate W.

In the example of FIG. 6, at a time point t1, the control unit 90 switches the supply valve 32i from the closed state to the open state. As a result, the drying liquid starts to be dispensed from the nozzle 30i toward the first main surface Wa of the substrate W. At this time point t1, a substantial drying liquid supply step starts. Further, for example, at the time point t1, the control unit 90 switches the supply valve 42 from the closed state to the open state and activates the heater 44. As a result, a high-temperature heat medium is dispensed from the nozzle 40 toward the second main surface Wb of the substrate W, and thus the substrate W is heated. In the example of FIG. 6, the medium temperature of the heat medium dispensed from the nozzle 40 is higher than a boiling point bp of the drying liquid.

When the heat medium starts to be dispensed, the substrate temperature at each position of the first main surface Wa of the substrate W rises over time. The substrate temperature may rise at a high rate of rise up to a certain point, and then rise gradually or converge. As illustrated in FIG. 6, the substrate temperature at each position on the first main surface Wa of the substrate W is lower than the boiling point bp of the drying liquid. This is because, as described above, the flow rate control valve 33i adjusts the flow rate of the drying liquid so that the substrate temperature becomes lower than the boiling point bp of the drying liquid. In the example of FIG. 6, since the heat medium lands at the central portion of the second main surface Wb of the substrate W, the substrate temperature of the first main surface Wa of the substrate W has a temperature distribution to be described below. In other words, as illustrated in FIG. 6, the substrate temperature is higher at the central portion of the substrate W and decreases radially outward.

The control unit 90 switches the supply valve 32i and the supply valve 42 from the open state to the closed state at a time point t2, which is later than the time point t1. In other words, at the time point t2, the substantial drying liquid supply step ends. The substrate temperature at the central portion of the first main surface Wa at the time point t2 is, for example, 70 degrees Celsius or higher, and can be, for example, about 80 degrees Celsius. Further, the substrate temperature of the peripheral edge portion of the first main surface Wa at the time point t2 is, for example, 60 degrees Celsius or higher, and specifically can be about 70 degrees Celsius.

As described above, the substrate temperature in the drying liquid supply step is lower than the boiling point bp of the drying liquid. For this reason, boiling of the drying liquid in the drying liquid supply step can be more reliably suppressed. If the drying liquid on the first main surface Wa of the substrate W boils during supply, it will cause particles to adhere to the first main surface Wa. In the present embodiment, since the boiling of the drying liquid is more reliably suppressed, the adhesion of particles to the first main surface Wa of the substrate W can be more reliably suppressed.

Moreover, in the drying liquid supply step, the temperature of at least a portion of the second main surface Wb of the substrate W is equal to or higher than the boiling point bp of the drying liquid. For this reason, in the drying liquid supply step, a maximum value in the temperature distribution of the first main surface Wa of the substrate W can be brought closer to the boiling point bp. A minimum value in the temperature distribution of the first main surface Wa of the substrate W in the drying liquid supply step (that is, the substrate temperature at the peripheral edge portion of the first main surface Wa) is, for example, 60 degrees Celsius or higher. In other words, the flow rate of the drying liquid can be set such that the substrate temperature at each position of the first main surface Wa of the substrate W is 60 degrees Celsius or higher and lower than the boiling point bp of the drying liquid.

For this reason, in the present embodiment, in the drying liquid supply step, the temperature of the drying liquid on the first main surface Wa of the substrate W can be brought closer to the boiling point bp. Therefore, the temperature of the drying liquid can be further increased in the drying step immediately after the supply of the drying liquid is stopped. For this reason, in the drying step, it is possible to further increase an evaporation rate of the drying liquid while further reducing the surface tension of the drying liquid. By reducing the surface tension, the collapse rate of the pattern can be effectively reduced. Further, since the drying liquid can be evaporated in a shorter time, it is also possible to reduce an impulse on the pattern due to the surface tension of the drying liquid during evaporation. This also makes it possible to effectively reduce the collapse rate of the pattern.

Further, the substrate heating unit 4 supplies the heat medium to the second main surface Wb of the substrate W to heat the substrate W. According to this, the substrate heating unit 4 can heat at least a portion of the second main surface Wb of the substrate W to a temperature equal to or higher than the boiling point of the drying liquid with a simple configuration.

Note that, in the example described above, although the dispenser 3 dispenses a normal-temperature drying liquid, it may dispense a high-temperature drying liquid. For example, the dispenser 3 may further include a heater (not illustrated). The heater is provided in the supply pipe 31i and heats the drying liquid flowing through the supply pipe 31i. The heater is controlled by the control unit 90. The heater heats the drying liquid so that the temperature of the drying liquid is higher than normal temperature and lower than the boiling point bp of the drying liquid. For example, the heater may raise the temperature of the drying liquid to 60 degrees Celsius or higher, and as a specific example, may raise the temperature to about 70 degrees Celsius.

### <Second Embodiment>

It has been found that the collapse rate of the pattern tends to be higher at the peripheral edge portion than at the central portion of the first main surface Wa of the substrate W. Therefore, in the second embodiment, an attempt is made to reduce the collapse rate of the pattern particularly at the peripheral edge portion of the first main surface Wa of the substrate W.

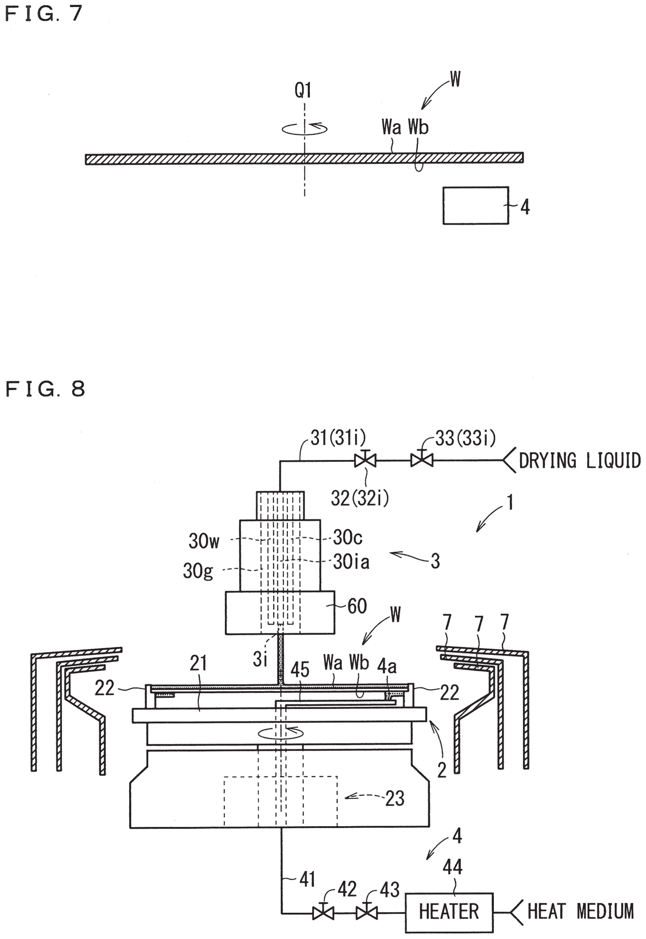

An example of the configuration of the substrate processing apparatus 100 according to the second embodiment is similar to that of the first embodiment. However, the specific configuration of the substrate heating unit 4 of the processing unit 1 is different from that of the first embodiment. FIG. 7 is a diagram schematically illustrating a first example of the substrate heating unit 4 according to the second embodiment. FIG. 7 also illustrates the substrate W held by the substrate holding unit 2. In the example of FIG. 7, the substrate heating unit 4 is provided at a position facing the peripheral edge portion of the second main surface Wb of the substrate W held by the substrate holding unit 2 in the vertical direction. The substrate heating unit 4 heats the peripheral edge portion of the second main surface Wb of the substrate W to a temperature equal to or higher than the boiling point bp of the drying liquid.

FIG. 8 is a diagram schematically illustrating a first example of the configuration of a portion of the processing unit 1 according to the second embodiment. In the example of FIG. 8, the substrate heating unit 4 includes a lead-out pipe 45 instead of the nozzle 40. The lead-out pipe 45 is provided directly below the substrate W held by the substrate holding unit 2. Specifically, the lead-out pipe 45 is provided between the substrate W held by the substrate holding unit 2 and the spin base 21. The lead-out pipe 45 extends along the radial direction, and the upstream end thereof is connected to the downstream end of the supply pipe 41. The downstream end of the lead-out pipe 45 is located radially inward of the chuck pin 22 of the substrate holding unit 2. In the lead-out pipe 45, a dispense port 4a facing the peripheral edge portion of the second main surface Wb of the substrate W in the vertical direction is formed. A heat medium is dispensed from the dispense port 4a of the lead-out pipe 45, and the heat medium lands at the peripheral edge portion of the second main surface Wb of the substrate W. The heat medium that has landed on the second main surface Wb moves radially outward with the rotation of the substrate W and scatters outward from the peripheral edge of the substrate W. For this reason, the substrate heating unit 4 heats the peripheral edge portion of the second main surface Wb of the substrate W. A distance between a liquid landing position of the heat medium on the second main surface Wb and the rotation axis Q1 may be 60% or more, 70% or more, 80% or more, or 90% or more of a radius of the substrate W.

Similarly to the first embodiment, the substrate heating unit 4 supplies a heat medium having a temperature equal to or higher than the boiling point bp of the drying liquid to the second main surface Wb of the substrate W. The medium temperature of the heat medium is, for example, about 85 degrees Celsius. The substrate heating unit 4 can heat the peripheral edge portion of the second main surface Wb of the substrate W to a temperature equal to or higher than the boiling point bp of the drying liquid. The temperature of the first main surface Wa of the substrate W decreases as the distance from the liquid landing position of the heat medium increases in the radial direction.

An example of the operation of the processing unit 1 according to the first example of the second embodiment is similar to that shown in the flowchart of FIG. 4. However, in the second embodiment, in the drying liquid supply step (step S5), the substrate heating unit 4 heats the peripheral edge portion of the second main surface Wb of the substrate W to a temperature equal to or higher than the boiling point bp of the drying liquid. In other words, the central portion of the second main surface Wb of the substrate W is not heated significantly.

Further, similarly to the first embodiment, in the drying liquid supply step, the processing unit 1 supplies the drying liquid to the first main surface Wa of the substrate W at a flow rate at which the temperature of the first main surface Wa of the substrate W becomes lower than the boiling point bp of the drying liquid.

As described above, in the first example of the second embodiment, since the substrate heating unit 4 heats the peripheral edge portion of the second main surface Wb of the substrate W, the temperature of the peripheral edge portion of the first main surface Wa of the substrate W can be intensively raised. For example, the substrate temperature at the peripheral edge portion (liquid landing position) of the first main surface Wa of the substrate W can be raised to about 80 degrees Celsius.

For this reason, in the drying step immediately after the supply of the drying liquid is stopped, the temperature of the drying liquid on the peripheral edge portion of the first main surface Wa of the substrate W can be further increased. Therefore, in the drying step, the evaporation rate of the drying liquid on the peripheral edge portion can be further increased while the surface tension of the drying liquid on the peripheral edge portion can be further reduced. As a result, it is possible to effectively reduce the collapse rate of the pattern at the peripheral edge portion of the first main surface Wa of the substrate W.

As described above, since the collapse rate of the pattern at the peripheral edge portion tends to be higher than the collapse rate of the pattern at the central portion, the collapse rate of the pattern over the entire first main surface Wa of the substrate can be reduced by reducing the collapse rate of the pattern at the peripheral edge portion.

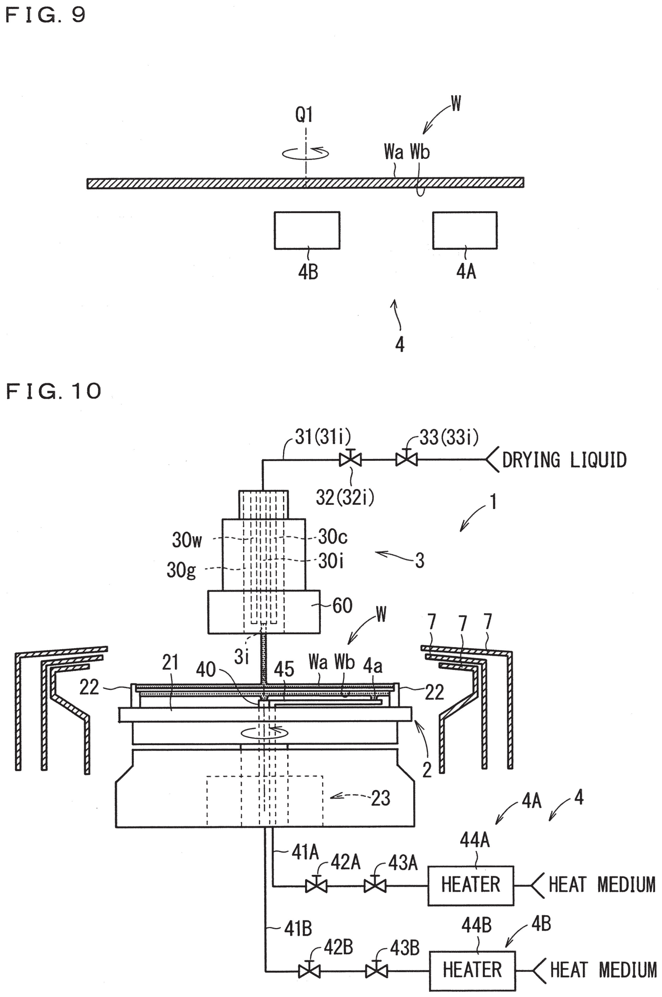

FIG. 9 is a diagram schematically illustrating a second example of the substrate heating unit 4 according to the second embodiment. FIG. 9 also illustrates the substrate W held by the substrate holding unit 2. In the example of FIG. 9, substrate heating unit 4 includes a peripheral heating unit 4A and a central heating unit 4B. The peripheral heating unit 4A is provided at a position facing the peripheral edge portion of the second main surface Wb of the substrate W held by the substrate holding unit 2 in the vertical direction. The peripheral heating unit 4A heats the peripheral edge portion of the second main surface Wb of the substrate W to a temperature equal to or higher than the boiling point bp of the drying liquid. The central heating unit 4B is provided radially inward of the peripheral heating unit 4A, and is provided at a position facing the central portion of the second main surface Wb of the substrate W in the vertical direction. The central heating unit 4B heats the central portion of the second main surface Wb of the substrate W. The central heating unit 4B heats the central portion of the second main surface Wb to, for example, a temperature lower than that of the peripheral edge portion of the second main surface Wb.

FIG. 10 is a diagram schematically illustrating a second example of the configuration of a portion of the processing unit 1 according to the second embodiment. In the example of FIG. 10, the peripheral heating unit 4A supplies a heat medium to the peripheral edge portion of the second main surface Wb of the substrate W, and the central heating unit 4B supplies a heat medium to the central portion of the second main surface Wb of the substrate W. The peripheral heating unit 4A and the central heating unit 4B can supply the heat medium at different medium temperatures. In the example of FIG. 10, the peripheral heating unit 4A includes a supply pipe 41A, a supply valve 42A, a flow rate control valve 43A, a heater 44A, and the lead-out pipe 45. The supply pipe 41A, the supply valve 42A, the flow rate control valve 43A, and the heater 44A are similar to the supply pipe 41, the supply valve 42, and the heater 44 in FIG. 8, respectively. In the example of FIG. 10, the central heating unit 4B includes a supply pipe 41B, a supply valve 42B, a flow rate control valve 43B, a heater 44B, and the nozzle 40. The supply pipe 41B, the supply valve 42B, the flow rate control valve 43B, and the heater 44B are similar to the supply pipe 41, the supply valve 42, and the heater 44 in FIG. 3, respectively. Portions of the supply pipe 41A and the supply pipe 41B are provided so as to be adjacent to each other in the hollow portion of the shaft 231.

The heater 44A heats the heat medium so that the first medium temperature of the heat medium dispensed from the dispense port 4a of the lead-out pipe 45 becomes equal to or higher than the boiling point bp of the drying liquid. The heater 44B heats the heat medium so that the second medium temperature of the heat medium dispensed from the dispense port of the nozzle 40 becomes, for example, lower than the first medium temperature. The first medium temperature may be, for example, about 85 degrees Celsius, and the second medium temperature may be, for example, about 70 degrees Celsius.

An example of the operation of the processing unit 1 according to the second example of the second embodiment is similar to that shown in the flowchart of FIG. 4. However, in the second example of the second embodiment, in the drying liquid supply step (step S5), the substrate heating unit 4 heats the central portion of the second main surface Wb of the substrate W to a temperature lower than that of the peripheral edge portion (for example, a temperature lower than the boiling point bp), while heating the peripheral edge portion of the second main surface Wb of the substrate W (at least the liquid landing position of the heat medium) to a temperature equal to or higher than the boiling point bp of the drying liquid. Specifically, in the drying liquid supply step, the control unit 90 opens the supply valve 42A and the supply valve 42B. Further, the heater 44A heats the heat medium so that the first medium temperature of the heat medium is equal to or higher than the boiling point bp of the drying liquid, and the heater 44B heats the heat medium in a range in which the second medium temperature of the heat medium is lower than the first medium temperature. The second medium temperature is, for example, lower than the boiling point bp.

On the other hand, the substrate temperature at the central portion of the first main surface Wa of the substrate W is, for example, about 70 degrees Celsius, and the substrate temperature at the peripheral edge portion of the first main surface Wa of the substrate W is, for example, about 80 degrees Celsius. Here, the substrate temperature at the central portion of the first main surface Wa of the substrate W is, for example, the substrate temperature at a position facing the liquid landing position of the heat medium from the nozzle 40 in the vertical direction, and the substrate temperature at the peripheral edge portion is, for example, the substrate temperature at a position facing the liquid landing position of the heat medium from the lead-out pipe 45 in the vertical direction.

As described above, also in the second example of the second embodiment, the substrate heating unit 4 heats the peripheral edge portion of the second main surface Wb of the substrate W. For this reason, for example, the substrate temperature at the peripheral edge portion (liquid landing position) of the first main surface Wa of the substrate W can be raised to about 80 degrees Celsius. Therefore, it is possible to reduce the collapse rate of the pattern at the peripheral edge portion of the first main surface Wa of the substrate W.

Further, in the second example of the second embodiment, the substrate heating unit 4 also heats the central portion of the second main surface Wb of the substrate W. However, the substrate temperature at the central portion of the first main surface Wa of the substrate W is lower than the substrate temperature at the peripheral edge portion. Since the collapse rate of the pattern at the peripheral edge portion of the substrate W tends to be lower, the collapse rate of the pattern at the central portion can be sufficiently reduced even if the substrate temperature at the central portion is lower than the substrate temperature at the peripheral edge portion. Further, since the central portion of the substrate W is not excessively heated, the power consumption of the substrate heating unit 4 can be reduced. In other words, the processing unit 1 can further reduce the overall collapse rate of the pattern by reducing the collapse rate of the pattern at the central portion of the first main surface Wa of the substrate W while reducing the power consumption.

Further, the substrate heating unit 4 supplies a heat medium having the first medium temperature to the peripheral edge portion of the second main surface Wb of the substrate W, and supplies a heat medium having the second medium temperature to the central portion of the second main surface Wb of the substrate W. For this reason, the processing unit 1 can reduce the collapse rate of the pattern over the entire first main surface Wa of the substrate W with a simple configuration.

Note that, in the example described above, the substrate heating unit 4 includes the peripheral heating unit 4A and the central heating unit 4B, but it may include three or more heating units. The three or more heating units may be provided side by side in the radial direction. The three or more heating units heat different radial portions of the second main surface Wb of the substrate W. In this case, the heating unit provided closer to the peripheral edge portion of the substrate W may heat the corresponding portion of the second main surface Wb of the substrate W to a higher temperature.

### <Third Embodiment>

In the first embodiment and the second embodiment, the substrate heating unit 4 heats the second main surface Wb of the substrate W throughout the entire drying liquid supply time in the drying liquid supply step (step S5). However, the present invention is not necessarily limited thereto.

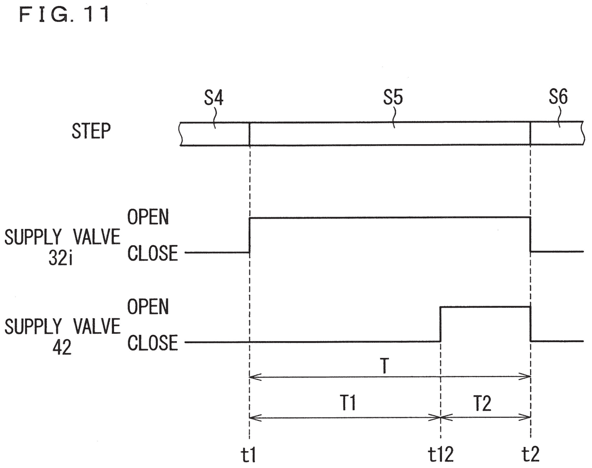

FIG. 11 is a diagram schematically illustrating an example of a timing chart of the processing unit 1 according to the third embodiment. In the example of FIG. 11, at a time point t1, the control unit 90 switches the supply valve 32i from the closed state to the open state. As a result, the drying liquid starts to be dispensed from the nozzle 30i toward the first main surface Wa of the substrate W. In other words, the substantial drying liquid supply step starts at the time point t1. On the other hand, in the example of FIG. 11, the control unit 90 switches the supply valve 42 from the closed state to the open state at a time point t12, which is later than the time point t1. As a result, a high-temperature heat medium starts to be dispensed from the nozzle 40 toward the second main surface Wb of the substrate W. In other words, the substrate heating unit 4 starts heating the second main surface Wb of the substrate W. Then, the control unit 90 switches the supply valve 32i and the supply valve 42 from the open state to the closed state at a time point t2, which is later than the time point t12. In other words, at the time point t2, the substantial drying liquid supply step ends.

As described above, in the third embodiment, during a drying liquid supply time T from the time point t1 to the time point t2, the substrate heating unit 4 does not heat the second main surface Wb of the substrate W during a predetermined former time period T1 from the time point t1 to the time point t12, but heats the second main surface Wb of the substrate W at a predetermined latter time period T2 from the time point t12 to the time point t2. The latter time period T2 is set in advance to a time period during which the temperature of the first main surface Wa of the substrate W at the time point t2 is sufficiently close to the boiling point bp of the drying liquid. For example, the latter time period T2 may be set to a half or less of the drying liquid supply time T, may be set to 1/3 or less, 1/4 or less, or 1/10 or less of the drying liquid supply time T.

As described above, in the third embodiment, the substrate heating unit 4 does not heat the substrate W during the former time period T1, but heats the second main surface Wb of the substrate W during the latter time period T2. In other words, the substrate heating unit 4 heats the second main surface Wb of the substrate W only during the latter time period T2. For this reason, an operation time of the substrate heating unit 4 can be shortened, and the power consumption of the substrate processing apparatus 100 can be reduced. Further, in a case where the substrate heating unit 4 supplies a high-temperature heat medium to the second main surface Wb of the substrate W, the amount of heat medium used can be reduced. In a case where the heat medium is a liquid, liquid-saving can be achieved.

### <Fourth Embodiment>

In the example described above, the processing unit 1 performs the chemical liquid step (step S3), the rinse step (step S4), the drying liquid supply step (step S5), and the drying step (step S6) in this order. However, the present invention is not necessarily limited thereto.

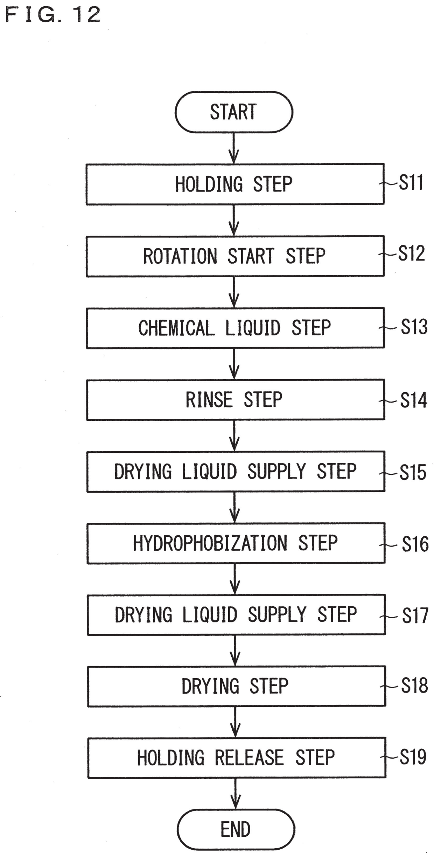

FIG. 12 is a flowchart illustrating a first example of an operation of the processing unit 1 according to the fourth embodiment. In the example of FIG. 12, the control unit 90 causes the processing unit 1 to execute the processing of steps S11 to S19 in accordance with a preset processing procedure (recipe). Steps S11 to S15 are similar to steps S1 to S5, respectively. However, in step S15 (the drying liquid supply step), the substrate heating unit 4 does not need to heat the substrate W.

Next, the processing unit 1 hydrophobizes the first main surface Wa of the substrate W (step S16: hydrophobization step: corresponding to a liquid supply step). Specifically, the processing unit 1 includes a nozzle that dispenses a hydrophobizing liquid, and causes the hydrophobizing liquid to be dispensed from the nozzle to the first main surface Wa of the rotating substrate W. The hydrophobizing liquid includes, for example, a silicon-based hydrophobizing liquid. The silicon-based hydrophobizing liquid is a hydrophobizing liquid that hydrophobizes silicon (Si) itself and a compound containing silicon. The hydrophobizing liquid is, for example, a silylation liquid containing a liquid silylating agent (also referred to as a silane coupling agent). The processing unit 1 stops the dispense of the hydrophobizing liquid from the nozzle when the first main surface Wa of the substrate W is sufficiently hydrophobized.

Next, the processing unit 1 executes steps S17 to S19. Steps S17 to S19 are similar to steps S5 to S7, respectively.

As described above, also in the first example described above, the drying liquid supply step (step S17) is executed in the same manner as the drying liquid supply step (step S5) in the first to third embodiments. For this reason, the collapse rate of the pattern of the substrate W can be reduced. Moreover, since the first main surface Wa of the substrate W is hydrophobized, a contact angle of the first main surface Wa can be reduced. For this reason, the surface tension acting on the pattern can be reduced, and the collapse rate of the pattern can be further reduced.

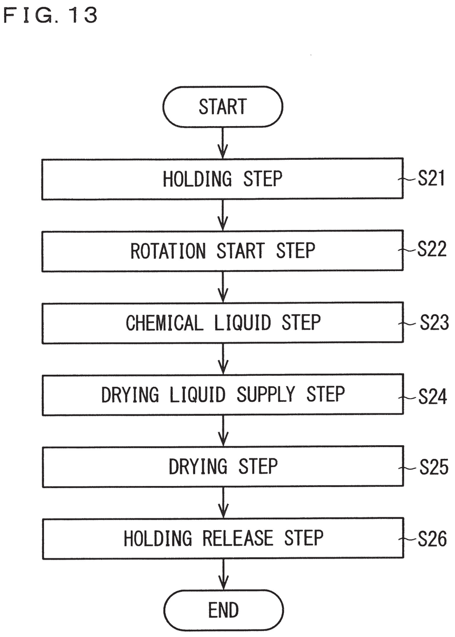

FIG. 13 is a flowchart illustrating a second example of the operation of the processing unit 1 according to the fourth embodiment. In the example of FIG. 13, the control unit 90 causes the processing unit 1 to execute the processing of steps S21 to S26 in accordance with a preset processing procedure (recipe). Steps S21 to S26 are similar to steps S1 to S3 and steps S5 to S7, respectively. However, at the end point of step S23 (the chemical liquid step: corresponding to a liquid supply step), metal is exposed on the first main surface Wa of the substrate W. According to the second example, after step S23, step S24 (the drying liquid supply step) is performed. For this reason, water is not supplied to the first main surface Wa of the substrate W. Therefore, a reaction between the metal and water can be avoided, and defects caused by the reaction can be avoided. Further, in the second example described above, the drying liquid supply step (step S24) is performed in the same manner as the drying liquid supply step (step S5) in the first to third embodiments. For this reason, the collapse rate of the pattern of the substrate W can be reduced.

### <Fifth Embodiment>

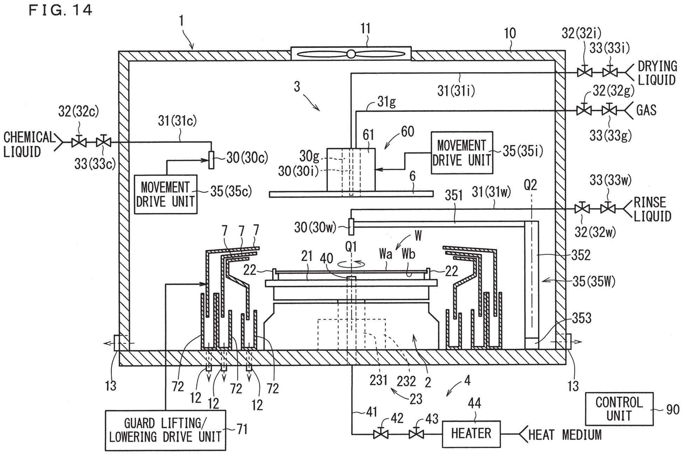

FIG. 14 is a diagram schematically illustrating an example of the configuration of the processing unit 1 according to the fifth embodiment. The processing unit 1 according to the fifth embodiment is different from the processing unit 1 according to the first embodiment in terms of the configuration of the dispenser 3 and the opposing member 60. In the example of FIG. 14, the opposing member 60 includes a shielding plate 6 and a hollow shaft 61. The shielding plate 6 is provided at a position facing the first main surface Wa of the substrate W held by the substrate holding unit 2 in the vertical direction. In the example of FIG. 14, since the first main surface Wa of the substrate W corresponds to the upper surface, the shielding plate 6 is provided vertically above the substrate W. The shielding plate 6 has, for example, a plate-like shape, and is provided in an orientation in which the thickness direction thereof is along the vertical direction. The lower surface of the shielding plate 6 is an opposing surface that faces the first main surface Wa of the substrate W. The shielding plate 6 has, for example, a circular shape in plan view. The diameter of the shielding plate 6 (that is, the diameter of the opposing surface) may be, for example, 80% or more, 90% or more of the diameter of the substrate W, or equal to or more than the diameter of the substrate W.

In the example of FIG. 14, a hollow shaft 61 is provided on the upper surface of the shielding plate 6. The hollow shaft 61 has a hollow portion, and a through hole that penetrates the shielding plate 6 in the vertical direction is formed in the central portion of the shielding plate 6. The hollow portion is connected to the through hole of the shielding plate 6 in the vertical direction. The nozzle 30i is provided in the hollow portion of the hollow shaft 61 and the through hole of the shielding plate 6. The diameter of an outer peripheral surface of the nozzle 30i is smaller than the diameter of the inner peripheral surfaces of the hollow shaft 61 and the shielding plate 6. A space between the outer peripheral surface of the nozzle 30i and the inner peripheral surfaces of the hollow shaft 61 and the shielding plate 6 functions as the gas flow path 30g.

In the example of FIG. 14, the nozzle 30c and the nozzle 30w are provided outside the opposing member 60. Further, in the example of FIG. 14, a movement drive unit 35c and a movement drive unit 35w are provided as the movement drive unit 35. The movement drive unit 35c moves the nozzle 30c between the processing position and the standby position, and the movement drive unit 35w moves the nozzle 30w between the processing position and the standby position.

In the example of FIG. 14, a movement drive unit 35i is provided as the movement drive unit 35. The movement drive unit 35i integrally moves the nozzle 30i and the opposing member 60. The movement drive unit 35i integrally moves the nozzle 30i and the opposing member 60, for example, along the vertical direction. In this case, it can be said that the movement drive unit 35i is a lifting/lowering drive unit. The movement drive unit 35i includes a drive source such as a motor, and a power transmission unit that transmits power from the drive source to the nozzle 30i and the shielding plate 6. The power transmission unit includes, for example, a cam mechanism or a ball screw mechanism.

The operation of the processing unit 1 according to the fifth embodiment is also similar to that shown in the flowchart of FIG. 4. However, the movement drive unit 35i lowers the nozzle 30i and the opposing member 60 to a processing position closer to the substrate W in the drying liquid supply step and the drying step, and lifts them to a standby position higher than the processing position in the other steps.

Also in the fifth embodiment, the drying liquid supply step (step S5) in the first to third embodiments is executed. For this reason, the collapse rate of the pattern at the peripheral edge portion of the substrate W can be reduced.

As described above, the substrate processing apparatus 100 and the substrate processing method have been described in detail, but the above description is illustrative in all aspects, and the present disclosure is not limited thereto. Further, the various modifications described above can be applied in combination as long as they do not contradict each other. It is understood that numerous modifications not illustrated can be assumed without departing from the scope of the present disclosure.

In the examples described above, a dedicated nozzle is provided for each fluid, but one nozzle may be shared by different types of fluids.

Further, in the examples described above, the substrate heating unit 4 supplies a heat medium to the second main surface Wb of the substrate W, but the present invention is not necessarily limited thereto. The substrate heating unit 4 may include, for example, a heater provided at a position facing the second main surface Wb of the substrate W in the vertical direction. The heater may be, for example, an electric resistance type heater including an electric heating wire, or may be an optical type heater that outputs light for heating.

For example, the peripheral heating unit 4A may be an electric resistance type heater or an optical heater. The peripheral heating unit 4A may be provided so as to surround the rotation axis Q1. The central heating unit 4B may also be an electric resistance type heater or an optical heater.

### EXPLANATION OF REFERENCE SIGNS

bp: boiling point
S1: holding step (step)
S4, S16, S23: liquid supply step (step)
S5, S17, S24: drying liquid supply step (step)
S6, S18, S25: drying step (step)
T: drying liquid supply time
T1: former time period
T2: latter time period
W: substrate
Wa: first main surface
Wb: second main surface

## Claims

1. A substrate processing method comprising:
a holding step of holding a substrate having a first main surface on which a pattern is formed and a second main surface on a side opposite to said first main surface;
a liquid supply step of supplying a processing liquid to said first main surface of said substrate;
a drying liquid supply step of supplying a drying liquid to said first main surface of said substrate at a flow rate at which a temperature of said first main surface of said substrate is lower than a boiling point of said drying liquid while heating at least a portion of said second main surface of said substrate to a temperature equal to or higher than the boiling point of said drying liquid, after said liquid supply step; and
a drying step of drying said substrate after said drying liquid supply step.

2. The substrate processing method according to claim 1, wherein
in said drying liquid supply step, a heat medium having a temperature equal to or higher than the boiling point of said drying liquid is supplied to said second main surface of said substrate.

3. The substrate processing method according to claim 1 or 2, wherein
in said drying liquid supply step, a peripheral edge portion of said second main surface of said substrate is heated to a temperature equal to or higher than the boiling point of said drying liquid.

4. The substrate processing method according to claim 3, wherein
in said drying liquid supply step, a central portion of said second main surface of said substrate is heated to a temperature lower than the temperature of said peripheral edge portion of said second main surface.

5. The substrate processing method according to claim 4, wherein
in said drying liquid supply step, a heat medium having a first medium temperature is supplied to said peripheral edge portion of said second main surface of said substrate, and a heat medium having a second medium temperature lower than said first medium temperature is supplied to said central portion of said second main surface of said substrate.

6. The substrate processing method according to claim 1 or 2, wherein
in said drying liquid supply step, said second main surface of said substrate is heated only during a latter time period of a drying liquid supply time during which said drying liquid is supplied.

7. The substrate processing method according to claim 1 or 2, wherein
in said drying liquid supply step, the temperature of said first main surface of said substrate is 60 degrees Celsius or higher and lower than the boiling point of said drying liquid.
